Europäisches Patentamt

European Patent Office

Office européen des brevets

(11) Publication number: **0 474 236 A2**

# EUROPEAN PATENT APPLICATION

(21) Application number: **91115025.8**

(22) Date of filing: **05.09.91**

(51) Int. Cl.5: **G01R 33/035**

(30) Priority: **07.09.90 JP 237959/90**

(43) Date of publication of application:
**11.03.92 Bulletin 92/11**

(84) Designated Contracting States:
**DE FR GB**

(71) Applicant: **DAIKIN INDUSTRIES, LIMITED**
**Umeda Center Building 4-12 Nakazaki-nishi**
**2-chome Kita-ku**
**Osaka 530(JP)**

(72) Inventor: **Ueda, Tomoaki**
**34-2, Ecchukitamachi, Nagaoka, Momoyama**
**Fushimi-ku, Kyoto-shi, Kyoto 612(JP)**

(74) Representative: **Prüfer, Lutz H., Dipl.-Phys. et**
**al**
**Harthauser Strasse 25d**
**W-8000 München 90(DE)**

(54) Magnetic flux locking apparatus.

(57) A constant bias current is supplied to a super-conducting quantum interference device (2). A pre-determined voltage is subtracted from output voltage from the superconducting quantum interference device (2). The predetermined voltage is determined to be a voltage which corresponds to a point in a monotonously varying portion of a magnetic flux-voltage conversion coefficient function of a super-conducting quantum interference device (2). The subtraction result is supplied to an integrator (4f). The integration result is converted to a current signal and then is supplied to a feedback coil (2c) of the superconducting quantum interference device (2).

Fig. 1

## Background of the Invention

The present invention relates to magnetic flux locking apparatus. More particularly, the present invention relates to apparatus for supplying a feedback signal to a feedback coil so as to compensate for variations in the magnetic flux which is guided to a superconducting loop of a superconducting quantum interference device (hereinafter referred to as SQUID) by an input coil when the SQUID is operated and housed in a casing which is cooled by a refrigerator to a temperature below the critical temperature for superconduction.

It is known that a SQUID is capable of detecting magnetic flux with extremely high sensitivity. With attention to this characteristic, a SQUID is applied to various apparatus which are used in various technical fields. A SQUID is classified as an rf-SQUID if it has only one Josephson junction (hereinafter referred to as JJ) and as a dc-SQUID if it has two JJs. The rf-SQUID was generally used in the past years, while the dc-SQUID is being widely used in recent years because two JJs having similar characteristics can be obtained due to improvements in thin film manufacturing engineering in recent years.

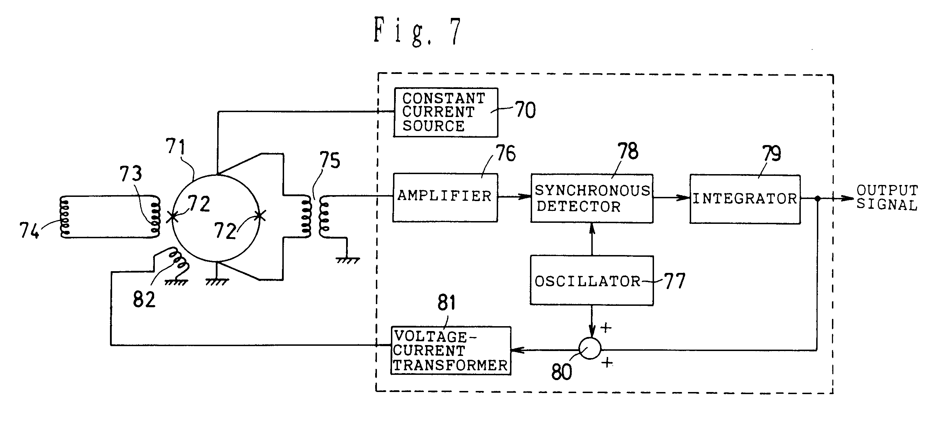

Figure 7 is an electric diagram for explaining the principle of a dc-SQUID flux meter.

The dc-SQUID includes a superconducting loop 71 and two JJs 72 which are provided at predetermined positions on the superconducting loop 71. A bias current is supplied to the opposite positions on the superconducting loop 71 with respect to the JJs 72 by a constant current source 70. An input coil 73, which is interconnected with a pickup coil 74 for detecting the magnetic flux of an object under measurement, is provided at a closed position on the superconducting loop 71. A voltage is output from the opposite positions on the superconducting loop 71 with respect to the JJs 72, the output voltage is transformed by a voltage transformation transformer 75 and then is amplified by an amplifier 76. The amplified voltage is demodulated by a synchronous detector 78 based on the modulated signal output from an oscillator 77, then the demodulated signal is integrated by an integrator 79 so as to output a voltage which is proportional to the exterior magnetic flux. Further, the output signal output from the integrator 79 and the modulated signal output from the oscillator 77 are added by an adder 80. The added signal is transformed into a feedback current by a voltage-current transformer 81, and the feedback current is supplied to a feedback coil 82 so as to eliminate variations of the exterior magnetic flux detected by the pickup coil 74.

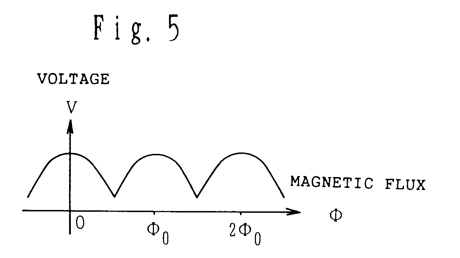

When the dc-SQUID is integrated into an magnetic flux locked loop (hereinafter referred to as FLL) having the arrangement shown in Fig. 7, the interlinkage magnetic flux of the superconducting loop 71 can be measured by maintaining the magnetic flux at a point having the highest transformation rate of magnetic flux to voltage, because the FLL dissolve the disadvantage that the interlinkage magnetic flux cannot be measured as it is due to the cyclic alteration of the transformation coefficient of the magnetic flux to the voltage based on the size of the interlinkage magnetic flux (refer to Fig. 5). More particularly, the magnetic flux which has the same size, and polarity which is the reverse of the externally supplied magnetic flux to the superconducting loop 71 through the pickup coil 74 and input coil 73, is fed back by the feedback coil 82 so as to cancel variations of the external magnetic flux. The external magnetic flux can be measured by monitoring the feedback current supplied to the feedback coil 82.

In the FLL having the arrangement above-mentioned, or output signal output from the integrator 79 includes noise having about half of the frequency of the modulation clock signal. The noise has a fairly decreased magnitude (for example, decreased about 80 decibels) due to the frequency characteristics of the integrator 79. The decreasing quantity is insufficient for the SQUID because the SQUID has an extremely high sensitivity. The oscillator 77 and the adder 80, which are used for modulating the output signal output from the integrator 79 and for supplying the modulated signal to the feedback coil 82, generate noises based on the modulation clock signal, which noises may influence the characteristics of the SQUID. When parameters such as the amplitude and the delay time of the modulation signal and the bias current and the like are to be determined, the parameters are to be adjusted by monitoring the output wave form of the SQUID. A disadvantage arises in that the adjusting operation becomes remarkably complicated.

The output voltage from the voltage transforming transformer 75 includes only alternating current components (does not include a direct current component), thereby the FLL cannot perform a characteristics test for the SQUID. When the characteristics test for the SQUID is to be performed, the SQUID should be interconnected to a characteristics test apparatus instead of the FLL. When SQUIDs and FLLs are provided for multichannel application, SQUIDs should be interconnected to thier own corresponding characterictics test apparatus. Therefore, it takes a remarkably long time period for the cooling down operation, and for returning to room temperature. The number of SQUIDs which can be housed together in a refrigerating chamber is limited due to defectiveness in thermal contact. Thereby it takes a remarkably long time period for testing the characteristics of the SQUIDs.

Summary of the Invention

It is an object of the present invention to supress noise generation as a whole.

It is another object of the present invention to carry out a characteristics test of a SQUID without changing the interconnection between the SQUID and a FLL when connecting the SQUID to a characteristics test apparatus.

To perform the former object, a magnetic flux locking apparatus according to the present invention comprises;

difference obtaining means for obtaining a difference signal representative of a difference between an output signal which is output from between opposite positions of a superconducting loop with respect to JJs of a SQUID supplied with a predetermined bias, and a predetermined signal which corresponds to a predetermined point in a monotonously varying portion of a magnetic flux-voltage characteristic function of the SQUID,

integrating means for integrating the difference signal to provide an integrated voltage signal, and

voltage-current converting means for converting the integrated voltage signal to a current signal which is supplied to a feedback coil of the SQUID.

When this magnetic flux locking apparatus is employed, the magnetic flux guided to the superconducting loop of the SQUID is maintained constant by supplying the feedback signal to the feedback coil for compensating for the variations in the quantity of the magnetic flux guided by the input coil to the superconducting loop of the SQUID, which SQUID is housed in a casing that is refrigerated to a temperature bolow the critical temperature for superconduction. The difference is obtained between the output signal which is output from the opposite positions of the superconducting loop, with respect to the JJs of the SQUID when the SQUID is supplied with the predetermined bias, and the predetermined signal which corresponds to the predetermined point in the monotonously varying portion of the magnetic flux-voltage characteristic function of the SQUID. The difference thus obtained is integrated by the integrating means to obtain the integrated signal. The integrated signal is converted to a current signal by the voltage-current converting means and the current signal is supplied to the feedback coil. Thus the magnetic flux is locked at the predetermined point in the monotonously varying portion of the magnetic flux-voltage characteristic of the SQUID.

As is apparent from the foregoing, a modulation circuit, conventionally required, can be omitted, the modulation circuit conventionally being used for supplying the feedback signal to the feedback coil, thereby the noise due to modulation is prevented from being generated. As a result, noise in the magnetic flux locking apparatus as a whole is decreased to a great extent. Also, the magnetic flux locking apparatus is simplified in its electrical arrangement and is miniaturized.

It is preferable that output selection means and supplying signal selection means are further provided. The output selection means selects the voltage signal of the prior stage of the difference obtaining means or the voltage signal of the following stage of the integrating means and outputs the selected voltage signal therefrom. The supplying signal selection means selects an externally supplied voltage signal or the integrated voltage signal output from the integrating means and supplies the selected voltage signal to the voltage-current converting means. The supplying signal selection means operates synchronously with the output selection means.

When this magnetic flux locking apparatus is employed, the same operation as the former magnetic flux locking apparatus is carried out by controlling the output selection means to select the voltage signal of the following stage of the integrating means, and by controlling the supplying signal selection means to select the integrated voltage signal output from the integrating means, and to supply the integrated voltage signal to the voltage-current converting means. When both selection means are controlled to select the other voltage signals, the output voltage from the SQUID depends upon the externally supplied voltage signal instead of the feedback signal. Therefore, current-voltage characteristic of the SQUID is measured by varying the bias current of the SQUID. The magnetic flux-voltage characteristic of the SQUID is measured by varying the externally supplied voltage signal. As is apparent from the foregoing, characteristics of the SQUID are simply measured by simple selection operations.

These and other objectives, features and advantages of the present invention will be more readily understood upon consideration of the present invention, in conjunction with the accompanying drawings.

Brief Description of the Drawings

Figure 1 is an electrical diagram showing an embodiment of a magnetic flux locking apparatus according to the present invention;

Figures 2 is a diagram illustrating a standard voltage which is applied to a subtracter;

Figure 3 is a schematic cross sectional view of a refrigeration casing which is applied in a magnetic flux measurement apparatus using SQUIDs;

Figure 4 is an electrical diagram showing another embodiment of a magnetic flux locking apparatus according to the present invention;

Figure 5 is a diagram illustrating a magnetic flux-voltage transformation coefficient of a SQUID;

Figure 6 is a diagram illustrating a bias current-voltage characteristic of a SQUID; and

Figure 7 is an electrical diagram showing a conventional dc-SQUID flux meter.

## Detailed Description of the Preferred Embodiments

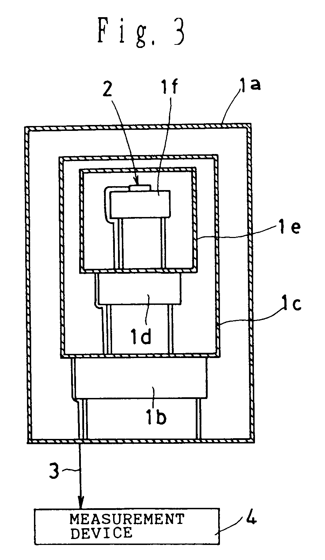

Figure 3 is a schematical cross sectional view of a refrigeration casing which is applied to a magnetic flux measurement apparatus using SQUIDs.

The refrigeration casing comprises;

a vacuum casing 1a,

a refrigerator 1b for refrigerating to 300K (300 Kelvin) which is provided in the vacuum casing 1a,

a shield 1c for radiant heat which is supported on the refregerator 1b,

a refrigerator 1d for refrigerating to 70K which is provided in a space surrounded by the shield 1c,

a shield 1e for radiant heat which is supported on the refrigerator 1d,

a refrigerator 1f for refrigerating to 4.2K which is provided in a space surrounded by the shield 1e,

at least one SQUID 2 which is supported by the refrigerator 1f, and

electrical lines 3 for interconnecting the SQUID 2 and a measurement device 4 which is provided exterior of the vacuum casing 1a.

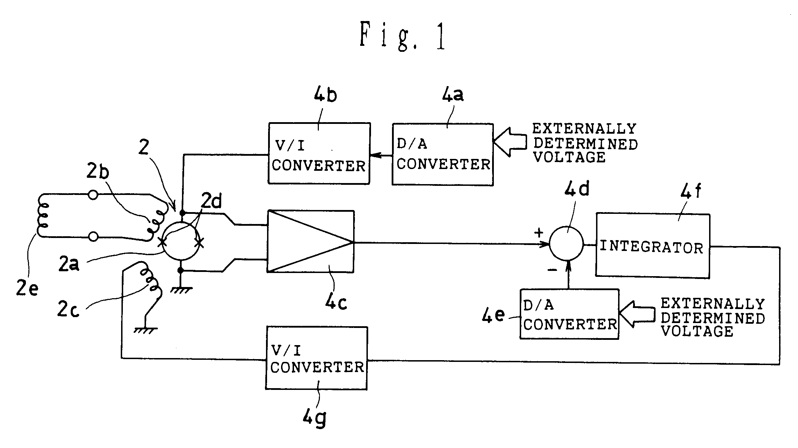

Figure 1 is an electrical diagram showing an embodiment of a magnetic flux locking apparatus according to the present invention.

A superconducting loop 2a of a SQUID 2 receives a bias current by a digital to analog converter (hereinafter referred to as a D/A converter) 4a and a voltage-current converter (hereinafter referred to as a V/I converter) 4b as a bias current supplying source. A pre-amplifier 4c receives a voltage signal from between the opposite positions of the superconducting loop 2a with respect to the JJs 2d and amplifies the received voltage signal. A subtracter 4d receives the amplified voltage signal at one input terminal, receives a predetermined standard voltage signal which is output from a D/A converter 4e at the other input terminal thereof and outputs a difference voltage signal representative of the difference between the amplified voltage signal and the predetermined standard voltage signal. An integrator 4f receives and integrates the difference voltage signal. A V/I converter 4g receives the integrated voltage signal output from the integrator 4f and converts the integrated voltage signal into a feedback current signal. A feedback coil 2c receives the feedback current and provides magnetic flux for compensating for variations in magnetic flux which is guided by an input coil 2b to the superconducting loop 2a of the SQUID 2. The input coil 2b guides the magnetic flux detected by the pickup coil 2e to the superconducting loop 2a with high efficiency. The D/A converters 4a and 4e receive voltage signals respecively which are determined externally thereof.

The operation of the magnetic flux locking apparatus having the arrangement mentioned above, is as follows.

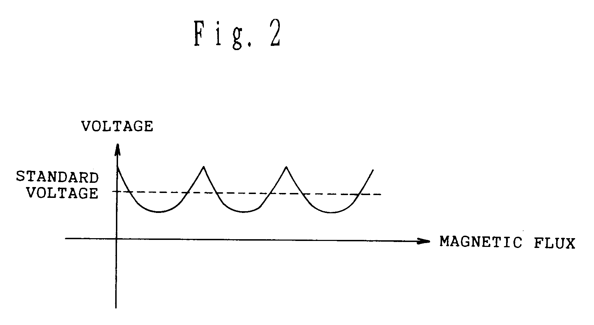

The bias current signal supplied by the D/A converter 4a and the V/I converter 4b to the superconducting loop 2a is determined according to a predetermined value. The standard voltage signal applied by the D/A converter 4e to the subtracter 4d is determined according to a value corresponding to a point in a monotonously varying portion of the magnetic flux-voltage characteristic function (refer to Fig. 2).

When the magnetic flux guided to the superconducting loop 2a by the input coil 2b varies in this condition, the voltage signal between the opposite positions of the superconducting loop 2a with respect to the JJs 2d varies. The varied voltage signal is amplified by the pre-amplifier 4c. The amplified voltage signal is applied to one input terminal of the subtracter 4d so as to provide the difference voltage signal representative of the difference between the amplified voltage signal and the standard voltage signal. The difference voltage signal is integrated by the integrator 4f so as to provide the feedback current signal. The feedback coil 2c receives the feedback current and provides and guides to the superconducting loop 2a magnetic flux for compensating for variations in magnetic flux which is guided by an input coil 2b to the superconducting loop 2a of the SQUID 2 so as to maintain the quantity of the magnetic flux guided to the superconducting loop 2a by the input coil 2b and the feedback coil 2c. That is, the quantity of the interlinkage magnetic flux of the superconducting loop 2a is maintained as a constant value. The magnetic flux guided to the superconducting loop 2a by the input coil 2b is detected based on the integration voltage signal output from the integrator 4f.

As is apparent from the foregoing, the modulation operation which is necessary in a conventional magnetic flux locking apparatus, is omitted, thereby the electrical arrangement is simplified as a whole. Also, the apparatus remarkably decreases the elements which are needed for adjustment, thereby the apparatus is miniaturized as a whole. Furthermore, driving amplifier circuits with a modulation clock signal are entirely omitted, thereby the quantity of noise generation is remarkably decreased.

Second Embodiment

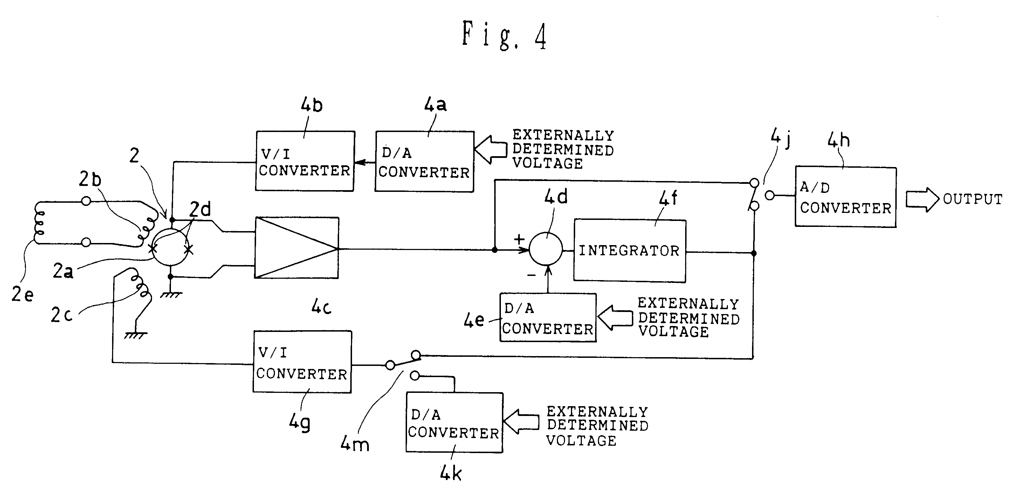

Figure 4 is an electrical diagram showing another embodiment of a magnetic flux locking apparatus according to the present invention.

This embodiment differs from the foregoing embodiment in that switches 4j and 4m, an analog-digital converter (hereinafter referred to as a A/D converter) 4h and a D/A converter 4k are further provided.

The switch 4j selects between applying the amplified voltage signal that also is applied to the subtracter 4d or the integrated voltage signal from the integrator 4f. The A/D converter 4h receives the voltage signal selected by the switch 4j and provides the digitalized voltage signal therefrom as an output voltage signal. The D/A converter 4k receives an externally supplied voltage signal in digital form and provides an analog voltage signal therefrom. The switch 4m selects between applying the analog voltage signal provided by the D/A converter 4k or the integrated voltage signal output from the integrator 4f and applies the selected voltage signal to the V/I converter 4g.

When this embodiment is employed, operation similar to that of the foregoing embodiment is carried out by controlling the switches 4j and 4m to select the integrated voltage signal output from the integrator 4f as is shown in Fig. 4.

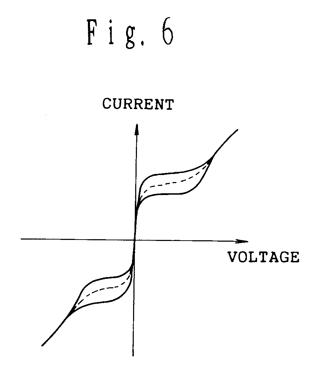

When both switches 4j and 4m are controlled to operate in an opposed condition, the subtracter 4d and the integrator 4f are disconnected. Thereby, the output voltage signal output from the SQUID 2 is output through the A/D converter 4h, the output voltage signal corresponding to the externally applied voltage signal through the D/A converter 4k. More specifically, when the externally applied voltage signal in digital form applied to the D/A converter 4k is varied while the externally applied voltage signal in digital form applied to the D/A converter 4a is kept to a constant value, this is equivalent to a condition in which external magnetic flux varies. Thereby, a magnetic flux-voltage characteristic (refer to Fig. 5) under the condition that the bias current signal is kept to a constant value, is measured. When the externally applied voltage signal in digital form applied to the D/A converter 4k is kept to a constant value while the externally applied voltage signal in digital form applied to the D/A converter 4a is varied, a current-voltage characteristic (refer to Fig. 6) is measured.

Furthermore, an adjusting operation for adjusting externally applied voltage signals which is necessary prior to starting the actual magnetic flux measurement using the SQUID 2, is simplified remarkably. More specifically, both switches 4j and 4m are operated to disconnect the subtracter 4d and the integrator 4f so as to prevent the magnetic flux locking operation from occurring. The D/A converters 4a, 4e and 4k are initialized to determine their output voltage to 0 volts. Then, the D/A converter 4k is set with a predetermined offset value, the D/A converter 4a is driven with a triangular wave or a sine wave and the voltage signal output from the A/D converter 4h is collected in synchronism with the driving of the D/A converter 4a, thereby the current-voltage characteristic (refer to the dash line in Fig. 6) corresponding to the offset value is obtained. Furthermore, the current-voltage characteristic shown in Fig. 6 is obtained by collecting the voltage signal output from the A/D converter 4h at every varying of the offset value of the D/A converter 4k, thereby a bias current signal range corresponding to the sensitivity of the SQUID 2 to the magnetic flux, is recognized.

After the current-voltage characteristic is obtained by the above-mentioned operation, the offset value of the D/A converter 4a is determined within the range of the bias current signal corresponding to the sensitivity of the SQUID 2 with the magnetic flux, the D/A converter 4k is driven with a triangular wave or a sine wave and the voltage signal output from the A/D converter 4h is collected in synchronism with the driving of the D/A converter 4k, thereby the magnetic flux-voltage characteristic corresponding to the offset value is obtained. Furthermore, the magnetic flux-voltage characteristic corresponding to each bias current signal is obtained by collecting the voltage signal output from the A/D converter 4h at every varying of the offset value of the D/A converter 4a, thereby a bias current signal which gives the maximum amplitude is recognized based on the plural magnetic-flux characteristics.

After the characteristics of the SQUID 2 are obtained by carrying out the above-mentioned series of operations, the switches 4j and 4m are controlled to select the voltage signal of a following stage of the integrator 4f and the integrated voltage signal output from the integrator 4f. Thereby the magnetic flux locking operation is ready to be carried out. Then, the offset value of the D/A converter 4a is determined according to the bias current value which gives the maximum amplitude of the magnet flux-voltage characteristic, while the offset value of the D/A converter 4e is determined according to the intermediate value between the maximum voltage and the minimum voltage of the magnet flux-voltage characteristic corresponding to the determined bias current value. Also, the integrator 4f is reset, thereby the magnetic flux measurement operation is ready to be carried out. Thereafter, the magnetic flux measurement operation is carried out under the determined condition.

When the magnetic flux measurement operation is carried out, the magnetic flux guided to the superconducting loop 2a is maintained at the predetermined position in the monotonously voltage varying portion. Thereby the external magnetic flux is measured by collecting the output voltage output from the integrator 4f through the A/D converter 4h. In this case, the accuracy in the magnetic flux measurement is remarkably improved because the bias current value is determined as mentioned above and the output voltage output from the integrator 4f is converted into a corresponding current by the V/I converter 4g which is supplied to the feedback coil 2c, the output voltage not being modulated at all.

As is apparent from the foregoing, the characteristic test condition and the magnetic flux measurement condition are easily selected by only controlling both switches 4j and 4m, and the bias current signal is remarkably easily adjusted when the magnetic flux measurement is carried out. Additionally, the number of components which need adjustment is remarkably decreased in comparison with the conventional magnetic flux locking apparatus.

The magnetic flux locking apparatus according to the present invention are not limited to the embodiments mentioned above. The magnetic flux locking apparatus may employ plural SQUIDs for multichannel application which are to be operated simultaneously. The initializing operation and determination of the bias current signal may be automated.

The terms and expressions which have been employed are used as terms of description and not of limitation, and there is no intention, in the use of such terms and expressions, to exclude equivalents of the features shown and described, or portions thereof, it being recognized that various modifications are possible within the scope of the invention as claimed.

**Claims**

1. A magnetic flux locking apparatus which maintains a magnetic flux guided to a superconducting loop (2a) of a SQUID (2) to a constant magnetic flux by supplying a feedback signal to a feedback coil (2c) of said SQUID (2) for compensation for variations in the magnetic flux guided to said superconducting loop (2a) by an input coil (2b), said SQUID (2) being housed in a casing (1e) which is refrigerated to a temperature below a critical temperature for superconduction, said apparatus comprising;

difference obtaining means (4d) for obtaining a difference signal representative of a difference between an output signal which is output from between opposite positions of said superconducting loop (2a) when a predetermined bias is applied to said SQUID (2), and a predetermined signal which corresponds to a predetermined point on a monotonously varying portion of a magnetic flux-voltage characteristic function of said SQUID (2),

integrating means (4f) for integrating a difference signal from said difference obtaining means (4d) to provide an integrated voltage signal, and

voltage-current converting means (4g) for converting an integrated voltage signal from said integrating means (4f) into a current signal which is supplied to said feedback coil (2c) of said SQUID (2) as said feedback signal.

2. A magnetic flux locking apparatus as set forth in claim 1, further comprising;

output selection means (4j) for selecting a selected voltage signal from either an output signal from between opposite positions of said superconducting loop (2a), or an integrated voltage signal from said integrating means (4f), and for outputting said selected voltage signal therefrom, and

supplying signal selection means (4m) for selecting an externally supplied voltage signal or an integrated voltage signal output from said integrating means (4f), and for supplying a selected voltage signal to said voltage-current converting means (4g), wherein said supplying signal selection means (4m) operates synchronously with said output selection means (4j).

Fig. 1

# Fig. 2

VOLTAGE

STANDARD
VOLTAGE

MAGNETIC FLUX

# Fig. 3

MEASUREMENT
DEVICE

Fig. 4

# Fig. 5

VOLTAGE

# Fig. 6

CURRENT

VOLTAGE

Fig. 7